# DEMANDE DE BREVET EUROPEEN

(11) **EP 3 668 288 A1**
(43) Date de publication de la demande: **17.06.2020**
(21) Numéro de dépôt: 19213444.3
(22) Date de dépôt: 04.12.2019
(51) Int. Cl.: H05K 7/14

(54) **DISPOSITIF ÉLECTRIQUE COMPRENANT UN FILM ISOLANT**

(30) Priorité: 14.12.2018 FR 1872980
(71) Demandeur: Valeo Siemens eAutomotive France SAS, 95800 Cergy (FR)
(72) Inventeur: MORTAIN, Eloi, 92150 SURESNES (FR); MOCERI, Alwin, 78700 CONFLANS SAINTE-HONORINE (FR); PARIGOT, Baptiste, 78290 CROISSY-SUR-SEINE (FR)
(74) Mandataire: Argyma

(57) **Abrégé**

L'invention a pour objet un dispositif électrique comprenant :
un boîtier (10) comprenant une cavité (11) recevant un composant électronique, et
au moins un premier conducteur électrique connecté au composant électronique de manière à l'alimenter en énergie électrique,
ledit dispositif électrique étant caractérisé en ce qu'il comprend un premier film isolant (F1) électrique venant contre une surface du premier conducteur de manière à l'isoler électriquement, ledit premier film isolant (F1) possédant au moins un organe de maintien (F1-1) permettant la fixation du premier film isolant (F1) à un élément mécanique, notamment du dispositif électrique.

## Description

### DOMAINE TECHNIQUE DE L'INVENTION

La présente invention concerne un dispositif électrique présentant un système d'isolation électrique amélioré et un équipement électrique comprenant un tel dispositif électrique, notamment un convertisseur de tension, ou un chargeur électrique ou un onduleur.

L'équipement électrique est notamment destiné à un véhicule électrique ou hybride.

L'invention vise notamment à permettre une isolation électrique durable pour de tels dispositifs électriques.

### ETAT DE LA TECHNIQUE

Comme cela est connu, dans un véhicule automobile électrique ou hybride, une batterie d'alimentation haute tension assure une fonction d'alimentation en énergie électrique d'un système de motorisation électrique permettant la propulsion du véhicule. Plus précisément, afin de commander la machine électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Par ailleurs, afin d'être chargée, la batterie d'alimentation haute tension est par exemple connectée à un réseau électrique d'alimentation externe, notamment via un chargeur électrique embarqué comprenant notamment au moins un convertisseur de tension continu-continu.

L'onduleur comprend un logement, dédié à cet équipement et communément appelé « housing » par l'homme du métier. L'onduleur comprend également un bloc capacitif comprenant un boîtier adapté pour s'insérer dans le logement de l'onduleur. Le bloc capacitif comprend également une cavité, située à l'intérieur du boîtier, et une capacité de lissage, adaptée pour être insérée dans la cavité du boîtier. Le bloc capacitif permet de lisser le courant continu fourni par la batterie d'alimentation, avant sa conversion en un courant de commande alternatif. Cette capacité permet ainsi de supprimer les perturbations résiduelles du courant continu afin qu'il puisse être filtré et être converti en un courant de commande alternatif.

Le bloc capacitif comprend également au moins deux conducteurs, notamment un conducteur relié à la borne négative de la capacité et un conducteur relié à la borne positive de la capacité. Chaque conducteur se présente comme une lamelle en cuivre pliée par exemple. Ces conducteurs permettent ainsi de donner un accès simple aux bornes négative et positive de la capacité, afin de connecter simplement la capacité au reste du système.

Cependant les conducteurs sont disposés selon des plans parallèles distincts mais à proximité l'un de l'autre. Ainsi, une isolation doit être réalisée entre les conducteurs et également entre les conducteurs et le logement afin d'isoler ces éléments les uns des autres pour éviter tout risque de court-circuit pouvant empêcher un fonctionnement optimal de l'onduleur.

Selon l'état de la technique, une première solution consiste à utiliser un premier film isolant à placer entre les conducteurs et le logement et un deuxième film isolant à placer entre les conducteurs. Selon cette solution, le premier et le deuxième films isolants sont maintenus immobiles en les fixant notamment avec une matière adhésive, telle que de la colle.

Cependant, une matière adhésive peut présenter une durée de vie limitée, voire largement inférieure à la durée de vie d'un véhicule. Il est donc possible que la matière adhésive se détériore avec le temps et que des problèmes de courts-circuits surviennent.

Il existe donc un besoin pour une solution efficace et durable d'un système de fixation d'éléments d'isolation des différents éléments d'un équipement électrique, notamment d'un bloc capacitif.

### PRESENTATION DE L'INVENTION

Plus précisément, l'invention a pour objet un dispositif électrique comprenant :
un boîtier comprenant une cavité recevant un composant électronique, et
au moins un premier conducteur électrique connecté au composant électronique de manière à l'alimenter en énergie électrique,
ledit dispositif électrique étant remarquable en ce qu'il comprend un premier film isolant électrique venant contre une surface du premier conducteur de manière à l'isoler électriquement, ledit premier film isolant possédant au moins un organe de maintien permettant la fixation du premier film isolant à un élément mécanique, notamment du dispositif électrique.

Avantageusement, le dispositif électrique comprend un deuxième conducteur électrique connecté au composant électronique de manière à l'alimenter en énergie électrique, le premier et le deuxième conducteurs électriques étant superposés et s'étendant selon des plans parallèles distincts, et dans lequel l'élément mécanique est un deuxième film isolant positionné entre les conducteurs de manière à isoler le premier et le deuxième conducteurs l'un de l'autre.

De manière préférée, le deuxième film isolant du dispositif électrique comprend au moins un organe de maintien adapté pour être fixé à l'organe de maintien du premier film isolant.

De préférence, le deuxième film isolant du dispositif électrique possède au moins une excroissance s'insérant dans la cavité du boîtier pour être prise dans la masse d'un matériau de remplissage de la cavité du boîtier, ladite excroissance étant située à un bord opposé du deuxième film isolant par rapport à l'organe de maintien.

De manière préférée, le premier film isolant du dispositif électrique possède au moins une excroissance s'insérant dans la cavité du boîtier pour être prise dans la masse d'un matériau de remplissage de la cavité du boîtier, ladite excroissance étant située à un bord opposé du premier film isolant par rapport à l'organe de maintien.

Avantageusement, le premier film isolant du dispositif électrique est en plastique.

Selon une forme de réalisation, le premier film isolant du dispositif électrique est maintenu par un premier moyen mécanique, par exemple une matière adhésive, contre la surface du premier conducteur et par un deuxième moyen mécanique de nature différente, par exemple par soudure, sur l'élément mécanique.

Selon une autre forme de réalisation, le premier film isolant du dispositif électrique présente au moins une pliure de manière à épouser la surface du premier conducteur et est maintenu contre ladite surface du premier conducteur uniquement par le premier organe de maintien et par l'excroissance dudit premier film isolant.

L'invention concerne également un équipement électrique comprenant un logement et un dispositif électrique, logé dans ledit logement, équipement électrique dans lequel, ledit premier film isolant est configuré pour isoler électriquement le premier conducteur d'une paroi dudit logement de l'équipement électrique ou d'autres composants de l'équipement électrique situés dans ledit logement de l'équipement électrique, ledit deuxième film isolant électrique étant configuré pour isoler les conducteurs les uns des autres.

Avantageusement, l'équipement électrique est configuré pour être embarqué dans un véhicule, et formant un onduleur configuré de manière à alimenter un moteur électrique entrainant le véhicule depuis une batterie, ou un convertisseur continu-continu configuré pour convertir une tension entre une batterie d'alimentation haute tension et une batterie d'alimentation basse tension, ou un chargeur électrique configuré pour convertir une tension entre un réseau électrique extérieur au véhicule et une batterie du véhicule.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1 illustre le schéma d'un bloc capacitif ;
Fig. 2 illustre schématiquement le schéma des conducteurs du bloc capacitif illustré à la figure 1 ;
Fig. 3 représente le schéma du boîtier du bloc capacitif selon la figure 1 et de films isolants selon une forme de réalisation de l'invention ;
Fig. 4 représente le schéma des conducteurs du bloc capacitif illustré à la figure 1 et de films isolants selon une forme de réalisation de l'invention ;
Fig. 5 représente les films isolants seuls selon une forme de réalisation de l'invention ;
Fig. 6 illustre le schéma d'un équipement électrique selon une forme de réalisation de l'invention ;
Fig. 7 représente le schéma des conducteurs du bloc capacitif illustré à la figure 1 et de films isolants selon une autre forme de réalisation de l'invention.

Il faut noter que les figures exposent l'invention de manière détaillée pour mettre en œuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite notamment dans le contexte d'un équipement électrique, tel qu'un onduleur, destiné à un véhicule automobile électrique ou hybride sans que cela ne soit limitatif de la portée de la présente invention.

En effet, dans un véhicule automobile électrique ou hybride, la batterie d'alimentation haute tension assure la fonction d'alimentation en énergie électrique du système de motorisation électrique, permettant la propulsion du véhicule, notamment via un onduleur permettant de convertir le courant continu fourni par la batterie d'alimentation haute tension en un ou plusieurs courants de commande alternatifs, par exemple sinusoïdaux.

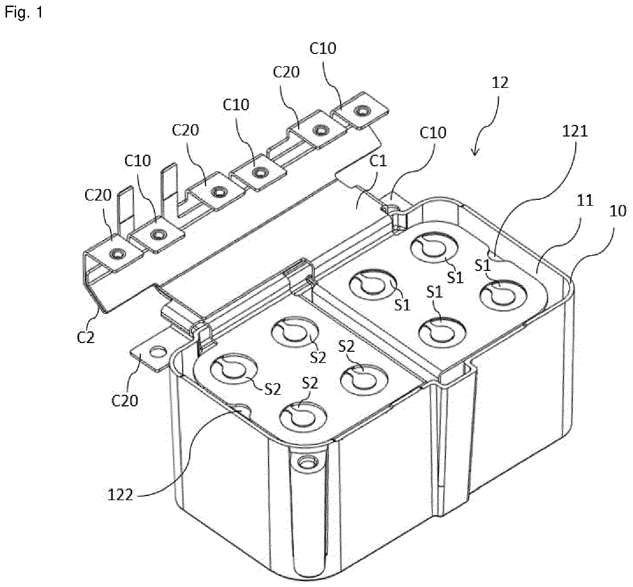

En référence à la figure 1, l'équipement électrique comprend un logement, qui lui est dédié, et communément appelé « housing » par l'homme du métier. Dans le cas présent, cet équipement électrique est un onduleur. L'onduleur comprend un bloc capacitif 12 comprenant un boîtier 10 adapté pour s'insérer dans le logement. Le bloc capacitif 12 comprend également une cavité 11, située à l'intérieur du boîtier 10, notamment définie par le boitier 10. Le bloc capacitif 12 comprend en outre des éléments capacitifs 121, 122, adaptés pour être insérés dans la cavité 11 du boîtier 10. Le bloc capacitif 12 permet de lisser le courant continu fourni par la batterie d'alimentation, avant sa conversion en un courant de commande alternatif. Ce bloc capacitif 12 comprenant une borne positive et une borne négative, permet ainsi de supprimer les perturbations résiduelles du courant continu afin qu'il puisse être filtré et être converti en un courant de commande alternatif, notamment par des interrupteurs électroniques non représentés. Les éléments capacitifs 121, 122 sont par exemple des capacités chimiques ou des capacités film, ou tout autre type d'élément capacitif.

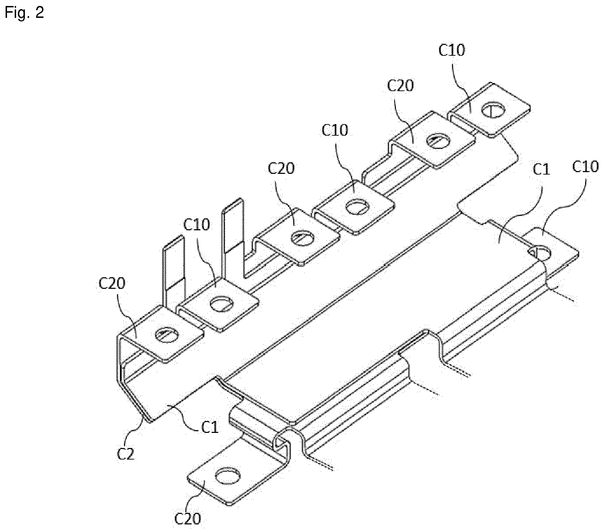

En référence aux figures 1 et 2, le bloc capacitif 12 comprend également au moins deux conducteurs C1, C2, disposés selon des plans parallèles distincts mais à proximité l'un de l'autre. Notamment, les conducteurs C1, C2 sont superposés l'un sur l'autre. Un premier conducteur C1 est relié aux bornes négatives respectives des éléments capacitifs 121, 122 du bloc capacitif 12. Un deuxième conducteur C2 est relié aux bornes positives respectives des éléments capacitifs 121, 122 du bloc capacitif 12. À cet effet, le bloc capacitif 12 peut comprendre des premières soudures S1 permettant de relier le premier conducteur C1 et les bornes négatives des éléments capacitifs 121, 122. En figure 1, le premier conducteur C1 est par exemple soudé sur une face du premier élément capacitif 121. Une portion du premier conducteur C1 passe entre les éléments capacitifs 121, 122 pour venir se connecter à une face opposée du deuxième élément capacitif 122. De même, le bloc capacitif 12 peut comprendre des secondes soudures S2 permettant de relier le deuxième conducteur C2 et les bornes positives des éléments capacitifs 121, 122. En figure 1, le deuxième conducteur C2 est par exemple soudé sur une face du deuxième élément capacitif 122. Une portion du deuxième conducteur C2 passe entre les éléments capacitifs 121, 122 pour venir se connecter à une face opposée du premier élément capacitif 121.

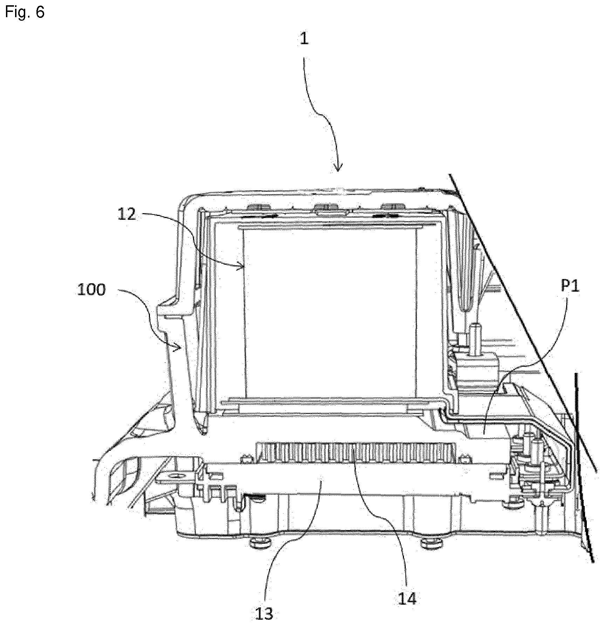

Par ailleurs, les conducteurs C1, C2 sont également situés à proximité d'une paroi P1 dudit logement de l'équipement électrique ou à proximité d'autres composants pouvant être situés dans ledit logement de l'équipement électrique. Par exemple, comme illustré en figure 6, l'équipement électrique 1, en l'espèce un onduleur, comprend notamment un bloc capacitif 12 et un module électronique de puissance 13 séparés par un circuit de refroidissement 14. Par ailleurs, le premier conducteur C1 est à proximité d'une paroi P1 du logement 100. Ladite paroi P1 est comprise notamment dans une face du circuit de refroidissement 14 destiné à refroidir des composants de l'équipement électrique 1, en particulier le bloc capacitif 12.

En référence à la figure 2, chaque conducteur C1, C2 comprend respectivement au moins une borne de connexion C10, C20 permettant de connecter les bornes négatives et positives du bloc capacitif 12 au reste du système afin notamment de distribuer l'énergie électrique au système de motorisation électrique. Par exemple, les bornes de connexion C10, C20 des conducteurs C1, C2 sont connectées à des bornes d'un module électronique de puissance 13.

Les bornes de connexion C10, C20 peuvent par exemple désigner une portion des conducteurs C1, C2. Afin de distribuer l'énergie électrique à d'autres composants, ces portions sont par exemple percées d'un ou plusieurs orifices, dans lesquels un connecteur est vissé. Ces portions peuvent être reliées au connecteur par d'autres moyens, par exemple par soudage.

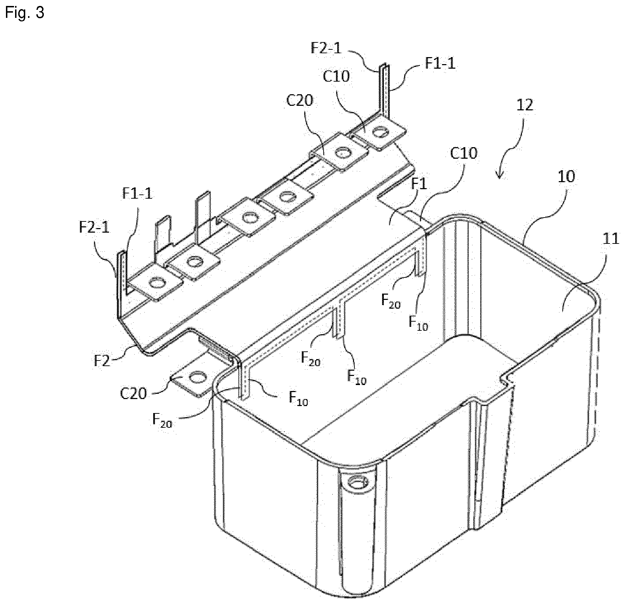

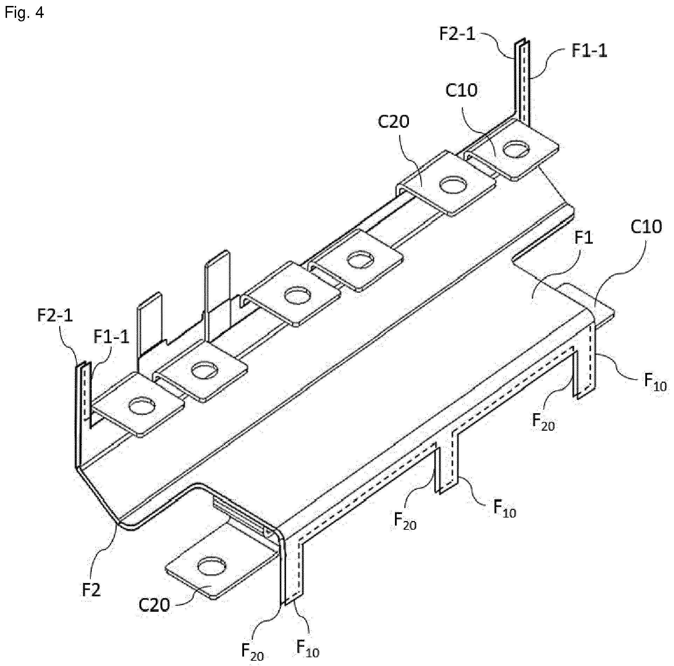

En référence aux figures 3 et 4 afin d'isoler électriquement les conducteurs C1, C2 du logement 100 et d'éviter ainsi tout court-circuit, le bloc capacitif 12 comprend un premier film isolant F1 placé contre le conducteur, parmi les au moins deux conducteurs C1, C2, le plus proche du logement 100, de manière à isoler ce conducteur électriquement du reste du logement 100. Dans la forme de réalisation présentée en référence aux figures 3 et 4, le premier film isolant F1 est placé contre la paroi du premier conducteur C1. Le premier film isolant F1 comporte au moins une excroissance F₁₀ et au moins un organe de maintien F1-1 permettant le maintien dudit premier film isolant F1 contre la surface du premier conducteur C1.

Ladite excroissance F₁₀ désigne une partie en saillie du premier film isolant F1. Cette excroissance F₁₀ est configurée pour s'étendre dans la cavité 11 du boîtier 10 afin d'être prise et fixée dans le matériau de remplissage de la cavité 11 du boîtier 10. Par ailleurs, le au moins un organe de maintien F1-1 désigne une autre partie en saillie du premier film isolant F1, placé par exemple à un bord opposé du premier film isolant F1 par rapport à la au moins une excroissance F₁₀. L'organe de maintien F1-1 est fixé à un élément mécanique du bloc capacitif 12. Ainsi, le premier film isolant F1 est maintenu sur un premier bord par l'organe de maintien F1-1 et à son bord opposé par l'excroissance F₁₀, ce qui améliore son maintien mécanique. En particulier, on pourrait se passer de matière adhésive pour maintenir le premier film isolant F1 contre la surface du premier conducteur C1. C'est en particulier le cas lorsque le premier film isolant F1 est suffisamment rigide pour être plié avant montage sur ledit premier conducteur C1 et conserver sa forme une fois monté sur ledit premier conducteur C1. Ainsi, la durée de vie d'une matière adhésive n'impacte pas la longévité du bloc capacitif 12.

En particulier, toujours en référence aux figures 3 et 4, ledit élément mécanique est un deuxième film isolant F2, inséré entre lesdits conducteurs C1, C2 et s'étendant jusque dans la cavité 11 du boîtier 10. Autrement dit, le deuxième film isolant F2 est maintenu en étant pris en sandwich entre les deux conducteurs C1, C2 du bloc capacitif 12. Ledit deuxième film isolant F2 est configuré pour isoler lesdits conducteurs C1, C2 l'un de l'autre et éviter tout court-circuit entre eux. En outre, ce deuxième film isolant F2 forme l'élément mécanique avec lequel le premier film isolant F1 est fixé. Ledit deuxième film isolant F2 comporte également au moins une excroissance F₂₀ et au moins un organe de maintien F2-1.

Ladite excroissance F₂₀ désigne une partie en saillie du deuxième film isolant F2. Cette excroissance F₂₀ est configurée pour s'étendre dans la cavité 11 du boîtier 10 afin d'être prise et fixée dans le matériau de remplissage de la cavité 11 du boîtier 10. Par ailleurs, le au moins un organe de maintien F2-1 désigne une autre partie en saillie du deuxième film isolant F2, adaptée pour être placée en vis-à-vis d'un organe de maintien F1-1 du premier film isolant F1.

Le premier film isolant F1 et le deuxième film isolant F2 sont notamment constitués de matière plastique.

En particulier, ledit matériau de remplissage est fluide lors du remplissage de la cavité 11 du boîtier 10, puis devient solide après une étape de polymérisation. Notamment le matériau de remplissage est une substance polymérisable, telle qu'une résine polymérisable par exemple, notamment une résine époxy.

Le au moins un organe de maintien F1-1 du premier film isolant F1 et le au moins un organe de maintien F2-1 du deuxième film isolant F2 sont configurés pour se fixer l'un à l'autre, par tout moyen adapté de soudure de plastique et notamment en utilisant un processus de soudure par ultrasons.

Ainsi, la fixation et le maintien du premier film isolant F1 et du deuxième film isolant F2 sont assurés d'un côté par les excroissances F₁₀, F₂₀ s'étendant dans le matériau de remplissage et d'un côté par la soudure réalisée entre les organes de maintien F1-1, F2-1.

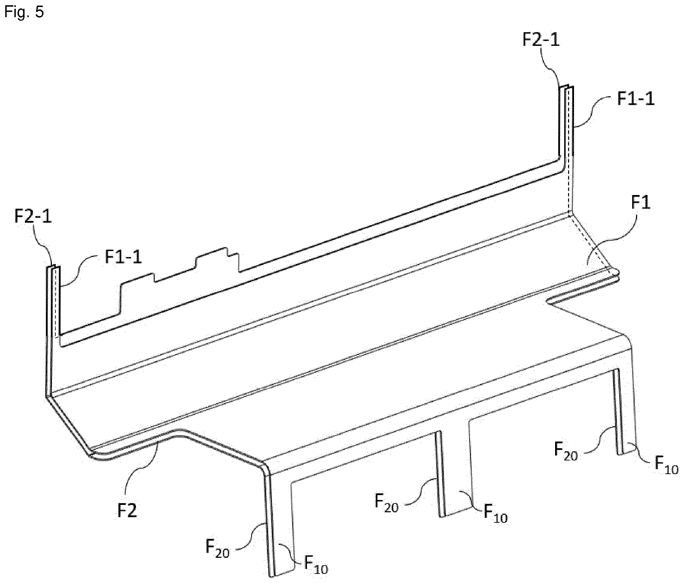

En référence à la figure 5, il est représenté le premier film isolant F1 et le deuxième film isolant F2 seuls, ainsi que leurs excroissances F₁₀, F₂₀ respectives et leurs organes de maintien F1-1, F2-1 respectifs.

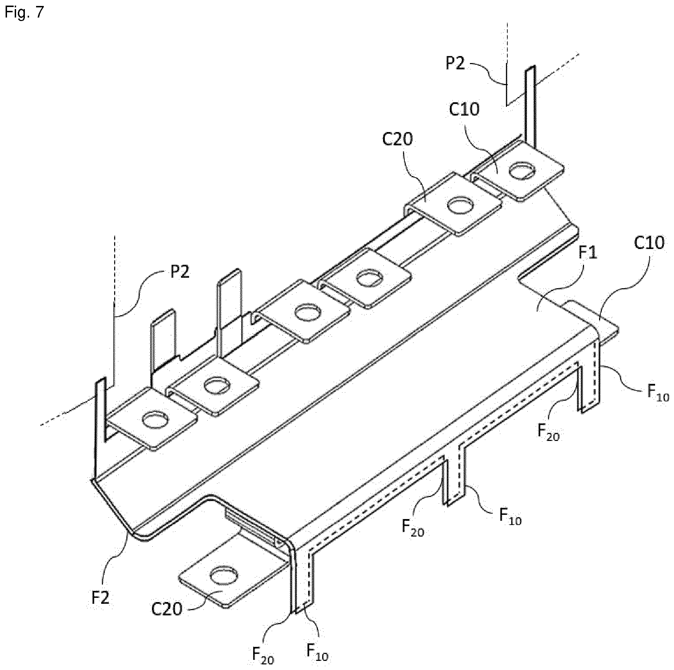

Au lieu d'être fixé sur le deuxième film isolant F2, le premier film isolant F1 pourrait être fixé sur un autre élément mécanique, notamment de l'équipement électrique 1. Ainsi, l'élément mécanique pourrait être une paroi P2 du logement, comme illustré par exemple en figure 7. Cette paroi P2 pourrait être alternativement une surface d'un autre composant électronique de l'équipement électrique 1.

## Revendications

1. Dispositif électrique comprenant :
un boîtier (10) comprenant une cavité (11) recevant un composant électronique, et
au moins un premier conducteur (C1) électrique connecté au composant électronique de manière à l'alimenter en énergie électrique,
ledit dispositif électrique étant **caractérisé en ce qu'**il comprend un premier film isolant (F1) électrique venant contre une surface du premier conducteur (C1) de manière à l'isoler électriquement, ledit premier film isolant (F1) possédant au moins un organe de maintien (F1-1) permettant la fixation du premier film isolant (F1) à un élément mécanique, notamment du dispositif électrique.

2. Dispositif électrique selon la revendication 1, comprenant un deuxième conducteur (C2) électrique connecté au composant électronique de manière à l'alimenter en énergie électrique, le premier et le deuxième conducteurs (C1, C2) électriques étant superposés et s'étendant selon des plans parallèles distincts, et dans lequel l'élément mécanique est un deuxième film isolant (F2) positionné entre les conducteurs (C1, C2) de manière à isoler le premier et le deuxième conducteurs (C1, C2) l'un de l'autre.

3. Dispositif électrique selon la revendication précédente, dans lequel le deuxième film isolant (F2) comprend au moins un organe de maintien (F2-1) adapté pour être fixé à l'organe de maintien (F1 -1) du premier film isolant (F1).

4. Dispositif électrique selon la revendication 2 ou 3, dans lequel le deuxième film isolant (F2) possède au moins une excroissance (F20) s'insérant dans la cavité (11) du boîtier (10) pour être prise dans la masse d'un matériau de remplissage de la cavité (11) du boîtier (10), ladite excroissance (F20) étant située à un bord opposé du deuxième film isolant (F2) par rapport à l'organe de maintien (F2-1).

5. Dispositif électrique selon l'une des revendications précédentes, dans lequel ledit premier film isolant (F1) possède au moins une excroissance (F10) s'insérant dans la cavité (11) du boîtier (10) pour être prise dans la masse d'un matériau de remplissage de la cavité (11) du boîtier (10), ladite excroissance (F10) étant située à un bord opposé du premier film isolant (F1) par rapport à l'organe de maintien (F1-1).

6. Dispositif électrique selon l'une des revendications précédentes, dans lequel le premier film isolant (F1) est en plastique.

7. Dispositif électrique selon l'une des revendications précédentes, dans lequel le premier film isolant (F1) est maintenu par un premier moyen mécanique, par exemple une matière adhésive, contre la surface du premier conducteur (C1) et par un deuxième moyen mécanique de nature différente, par exemple par soudure, sur l'élément mécanique.

8. Dispositif électrique selon l'une des revendications 5 à 7, dans lequel le premier film isolant (F1) présente au moins une pliure de manière à épouser la surface du premier conducteur (C1) et est maintenu contre ladite surface du premier conducteur (C1) uniquement par le premier organe de maintien (F1-1) et par l'excroissance (F10).

9. Equipement électrique (1) comprenant un logement (100) et un dispositif électrique, selon l'une des revendications 3 à 8, logé dans ledit logement (100), équipement électrique (1) dans lequel, ledit premier film isolant (F1) est configuré pour isoler électriquement le premier conducteur (C1) d'une paroi (P1) dudit logement (100) de l'équipement électrique (1) ou d'autres composants de l'équipement électrique (1) situés dans ledit logement (100) de l'équipement électrique (1), ledit deuxième film isolant (F2) électrique étant configuré pour isoler les conducteurs (C1, C2) les uns des autres.

10. Equipement électrique (1) selon la revendication précédente, configuré pour être embarqué dans un véhicule, et formant un onduleur configuré de manière à alimenter un moteur électrique entrainant le véhicule depuis une batterie, ou un convertisseur continu-continu configuré pour convertir une tension entre une batterie d'alimentation haute tension et une batterie d'alimentation basse tension, ou un chargeur électrique configuré pour convertir une tension entre un réseau électrique extérieur au véhicule et une batterie du véhicule.
